# EUROPEAN PATENT SPECIFICATION

(11) **EP 2 132 875 B1**
(45) Date of publication and mention of the grant of the patent: **22.08.2018**
(21) Application number: 08736166.3
(22) Date of filing: 11.04.2008
(51) Int. Cl.: H03L 1/02, G04F 5/06, G04G 3/04, G04G 3/02

(54) **METHOD FOR TEMPERATURE COMPENSATION OF A TIME BASIS**
VERFAHREN ZUM TEMPERATURAUSGLEICH EINER ZEITBASIS
PROCÉDÉ POUR LA COMPENSATION EN TEMPÉRATURE D'UNE BASE DE TEMPS

(30) Priority: 11.04.2007 EP 07105994
(43) Date of publication of application: 16.12.2009
(73) Proprietor: Microdul AG, 8045 Zürich (CH)
(72) Inventor: THOMMEN, Werner, 8003 Zürich (CH)
(74) Representative: Liebetanz, Michael
(86) International application number: PCT/EP2008/054459
(87) International publication number: WO 2008/125646

(56) References cited:
- US-A- 4 453 834
- US-A- 4 537 515
- RAPPO RENE: "Mouvements à quartz adaptés aux nouveaux critères COSC (Controle officiel Suisse des Chronomètres)" SOCIETE SUISSE DE CHRONOMETRIE. ACTES DE LA JOURNEE D'ETUDE, SOCIETE SUISSE DE CHRONOMETRIE, NEUCHATEL, CH, 1 January 2002 (2002-01-01), pages 33-36, XP008087841 ISSN: 1023-2680 cited in the application

## Description

### Technical field of the invention

The invention relates to temperature compensation of a time basis driven by a quartz crystal oscillator, a method and a device for performing such compensation.

A crystal oscillator is an electronic circuit that uses the mechanical resonance of a vibrating crystal of piezoelectric material to create an electrical signal with a very precise frequency. This frequency is used for different application, e.g. to keep track of time or to provide a stable clock signal for digital integrated circuits, and to stabilize frequencies for radio transmitters.

When quartz crystals are used, its piezoelectricity results that the quartz crystal behaves like a circuit composed of an inductor, capacitor and resistor, with a precise resonant frequency. Such crystal oscillators can be manufactured for frequencies from a few tens of kilohertz to tens of megahertz.

Usual application fields for such oscillators are wristwatches, cellphones, computers as well as test and measurement equipment, such as counters, signal generators, and oscilloscopes.

### Technical background of the invention

In numerous applications a 32'768 Hz tuning fork crystal is used. The temperature compensation of a time basis driven by such a 32'768 Hz tuning fork crystal is known. The tuning fork crystal is usually cut such that its frequency over temperature is a parabolic curve centered around 25 °C. This means that a tuning fork crystal oscillator will resonate close to its target frequency at room temperature, but will slow down when the temperature either increases or decreases from room temperature. A common parabolic coefficient for a 32'768 Hz tuning fork crystal is -0.04 ppm/°C².

From US 4,537,515, realized in a product from Longines (Conquest VHP) and marketed in 1985, the use of a second quartz as thermometer is known.

More recently a thermal compensation using an integrated thermometer in the electronic chip has been proposed. During the "Journée d'étude 2002 de la Société Suisse de Chronométrie (SSC)", René Rappo, ETA S.A., presented a paper called "Mouvements à quartz adaptés aux nouveaux critères COSC (Contrôle officiel Suisse des Chronomètres)». The compensation uses the adjustment of the division rate of the counting chain from 32'768 Hz to 1 Hz. This solution has been applied in Breitling and Omega market products. Within 8 minute periods in the first case, four and sixteen minute periods in the second case, a second has a different duration, in order to achieve an accurate average of the periodic watch rate.

In these known solutions, the principle of pulse inhibition in the divider chain, as known from CH 534 913, is applied. This principle requires that at whatever temperature the oscillator frequency must be always above the ideal frequency of 32'768 Hz. Indeed, this method can only slow down the average rate. Periodically one of second periods will be longer than or equal to the others.

The solution according to US 4,537,515 requires an additional component, the quartz thermometer, which is a disadvantage. This increases the electronic module bulk. Moreover, the quartz thermometer is not a standard component and has to be produced specially for the market.

Additionally both solutions only allow the simultaneous correction of temperature and the offset. It is then impossible to adjust the offset rate alone since the temperature compensation will also be affected.

The COSC ("Contrôle Officiel Suisse des Chronometres") is the Swiss Official Chronometer Testing Institute and comprise laboratories doing actual testing of the movements submitted by individual watch manufacturers to be granted the official chronometer status. Each movement is individually tested for fifteen days, in five positions, at three different temperatures. The above mentioned article from René Rappo provides a method to produce a movement which will satisfy the COSC requirements through using three rooms heated at the different temperatures, taking measurements of three different values at each temperature and calculating the offset and temperature compensation as required.

US 4,453,834 discloses a method for temperature compensation of a time basis, driven by a quartz crystal oscillator, wherein a second oscillator is used having a linear frequency dependency on temperature, wherein pulses of the quartz crystal oscillator are counted during time intervals given by a predetermined number of pulses of the second oscillator. Pulses counted for different temperatures are representative for said temperature.

### Summary of the invention

It is an object of the invention to provide an improved method to produce a movement which will satisfy the COSC requirements.

It is a further object of the invention to provide an improved method allowing to use less sophisticated measurement equipment as compared to prior art simulation of COSC testing for watches.

It is a further object of the invention to provide an improved method to provide a device having a simpler programmed compensation scheme.

The object of the invention is realized with a method comprising the features of claim 1 and a device according to claim 4.

The method for temperature compensation of a time basis, driven by a quartz crystal oscillator, comprises a second oscillator having a linear frequency dependency on temperature. The method counts the pulses of the quartz crystal oscillator for at least three different temperatures during time intervals given by a predetermined number of pulses of the second oscillator. Then the function of variation of the second oscillator period with temperature is calculated based on said three pulse count values. Therefore the temperature correction can be provided independently from any offset considerations and is not dependent on the choice of the three different temperatures.

In the case that the method is used for checking watches against the COSC norm, it is only necessary to provide one room at around 8°C and one room at around 38°C. Although the temperature during measurement has to be stable, the value of the actual temperature is not important. Additionally one measurement can be done at approximately room temperature, allowing for a simpler measurement approach.

It is possible to make the measurements using provisional circuitry if there is a good thermal contact between the quartz and the second oscillator at that very moment. Based on the evaluated values giving access to the simple programming of an ASIC, based on three values for the parabolic function, it is possible to reassemble a watch or any other electronic device using this method comprising said quartz and second oscillator at the end of the production line. Furthermore, it is then possible to independently provide for an offset correction of the quartz later on. This allows using the property of any quartz oscillator to approach its limit offset value after a number of days or longer, e.g. weeks or months.

The current value of compensation of the two types of compensation can then be checked very easily since the corrections for temperature and offset have opposite signs and can therefore be traced independently, if they are applied e.g. alternately.

The second oscillator can be chosen to be a relaxation oscillator, especially a RC-oscillator, having an oscillation frequency according to the product R * C and following a quasi-linear temperature dependency.

The invention enables compensating the frequency variation in a quartz watch:
- periodically correcting the temperature variation, and
- one time, i.e. during manufacturing and - optionally - later on, if a special service is needed, adjusting the quartz offset,
by discriminating these two sources of correction and by making individual measurements.

This approach allows to program two sets of compensation parameters at two stages of manufacturing, i.e. initially with a precise control at three programming temperatures and later, when the electronic module is placed in the watch case, introducing the influence of said watch case in the programming.

It is an advantage, especially for the after sales service to be able to test each of the two corrections in a separate way, if the reasons for frequency variations are evaluated.

Further objects and advantages are realized with features as described within the dependent claims.

### Short description of the drawings

The invention is now described by way of example with reference to the accompanying drawings.
- Fig. 1: shows a schematic representation of the frequency deviation for different temperatures for a temperature sensor and for a quartz crystal used in a method and device according to the invention,
- Fig. 2: shows a schematic representation of the counted pulses for relaxation circuit and the quartz oscillator,
- Fig. 3: shows a schematic representation of the behaviour of a tuning fork crystal as a function of the temperature,
- Fig. 4: shows a schematical representation of a device with temperature compensation of a time basis driven by a quartz crystal oscillator,
- Fig. 5: shows a schematic representation of the temperature compensation of the watch rate,
- Fig. 6: shows a schematic representation of the rate adjustment by inhibition,
- Fig. 7: shows a schematic representation of the combined temperature compensation of the watch rate and adjustment by inhibition, and
- Fig. 8: shows the influence and dependency of the load capacitance relative to the frequency relative gap of a quartz oscillator.

### Detailed description of embodiments of the invention

One embodiment of the invention relates to a method and an integrated circuit that improves the accuracy of the rate of an electronic watch. The time basis is driven by a 32'768 Hz tuning fork crystal. The watch rate is temperature compensated after a calibration procedure at three different temperatures and a specific programming for each circuit or watch movement.

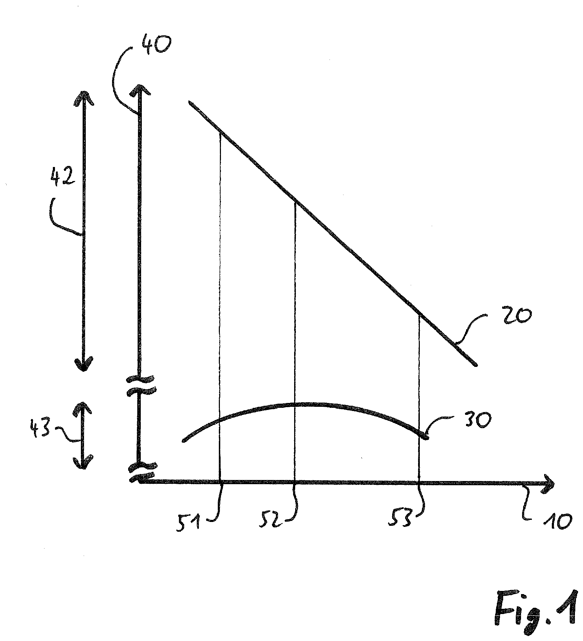

An integrated circuit according to the invention comprises a sensor with an output signal that has a linear and monotonic function 20 with temperature 10. The temperature compensation of the rate of a quartz time basis can be done using a relaxation oscillator having a period that varies quasi linearly with the temperature. Fig. 1 shows a schematic representation of the frequency deviation function 20 for a temperature sensor and of the frequency deviation function 30 for a quartz crystal.

The frequency deviation 40 is e.g. about 200'000 to 400'000 ppm according to double arrow 42 for the temperature interval in question, e.g. from -10°C to +50°C. The function behind the graph line 20 can be approached with a polynomial function of degree 1 (or linear function).

On the other hand, the temperature dependence 30 of the quartz itself is a parabolic function, wherein the frequency deviation 40 according to arrow 43 over the interesting temperature interval is in the order of 20 to 40 ppm.

Reference numerals 51, 52 and 53 denominate three different temperatures, e.g. around 8°C, around 23°C and around 38°C. They are chosen in the vicinity of the three temperatures used in the COSC certifying process, but they can also be chosen completely differently.

The sensitivity of such a relaxation oscillator is high compared to the variation of the quartz frequency. The relative variation of the period can reach 0.5% per degree centigrade, e.g. 5000 ppm. The variation of the quartz frequency, in absolute terms, is usually smaller than 2ppm/°C in the range of -10°C to 50°C.

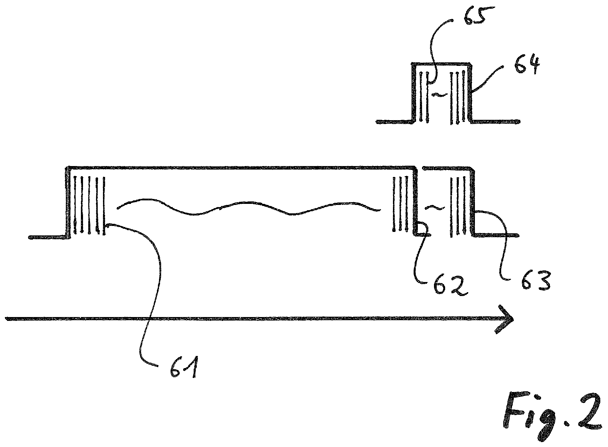

Fig. 2 shows a schematic representation of the counted pulses for the relaxation circuit and the quartz oscillator. On one hand, the relaxation oscillator allows generation of a time window W(T) varying with the temperature by counting a given number of pulses 61. Having the same virtual starting point, reference numeral 62 relates to an initial temperature T1 and reference numeral 63 relates to the length of the time interval at a different temperature T2. Two different reference numerals, i.e. 62 and 63, are chosen to show the length of the time interval, since they are different, although the number of pulses 61 is predetermined and equal.

In a different embodiment, the number of pulses 61 generating the time windows W(T1), W(T2) could be different, but then the following steps to calculate the differential time window would have to be adapted. Example: If at T2 3/2 the number of pulses used at T1 is used then the relevant time interval would be W'(T2)=2/3*W(T2), when W(T2) is the time interval generated with identical number of pulses 61.

On the other hand, the quartz frequency allows generation of a reference window W2, numeral 64 which can be considered to be independent of the temperature by counting another given number of pulses 65. It is then possible to generate a signal P(T) representing the variation of the relaxation oscillator period with the temperature obtained by counting the pulses 65 of the quartz oscillator during a time 64 equal to the difference of both windows W = W(T2)-W(T1). Inherently (counting the pulses), the quantity P(T) is an integer that depends on the temperature as given by the relaxation oscillator period. The length of W(T) is chosen to obtain a significant number of pulses for the difference. The number of pulses 61 can be chosen to be equivalent to 10 seconds, 1 minute or 10 minutes to name three examples. Said number can also be chosen to give a higher or lower measurement time.

In other words, a given number of pulses 61 issued by the relaxation oscillator is counted. The time necessary to the relaxation oscillator for generating these pulses depends on its temperature, thus generating time windows W(T) of different lengths. Therefore the point in time 62 relates to an initial temperature T1 and the point in time 63 relates to the length of the time interval at a different temperature T2. As mentioned below, the method uses and necessitates an additional time window W(T3) at a different temperature T3.

Pulses generated by the quartz frequency are counted for each temperature (T1, T2 and T3) and there will be a different number of pulses generated by the quartz frequency creating said different reference windows W2, relating to a number of pulses 65, wherein the representation of Fig. 2 is based on a virtual (identical) starting point.

Therefore the above mentioned steps allow measuring the periods D1_{T1}, D2_{T2} and D3_{T3} derived from the relaxation oscillator and the relative gap of the quartz frequency Y_{T1}, Y_{T2} and Y_{T3} in comparison with a nominal value of 32'768 Hz to be used in the calibration step as explained below. Therein T1, T2 and T3 are three different temperatures, wherein the description of obtaining the pulses of window W2 is related to the window between T1 and T2 or T2 and T3 or T1 and T3, respectively. It is known to someone skilled in the art that the parabolic function 30 as shown in Fig. 1 is well defined with three values, since a polynomial equation having exponent two is a quadratic (square-like) equation having three coefficients. Therefore it is directly possible to calculate the function of variation 30 of the second oscillator period with temperature based on three pulse count values, but of course more than three pulse count values for more different temperatures may be used. The compensation step then uses said calculated function to correct the frequency change of the quartz crystal oscillator 101 due to temperature changes at any operating temperature, i.e. at temperatures T for which hold: T<T1, T1<T<T2, T2<T<T3 or T3<T.

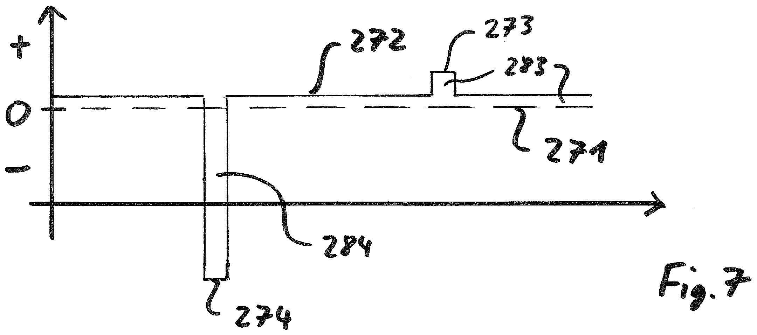

In order to control the final product, one embodiment of the invention uses the integration of time over two minutes to demonstrate the value of the temperature correction and the value of the offset correction. Such an example will be shown later on in connection with Fig. 7.

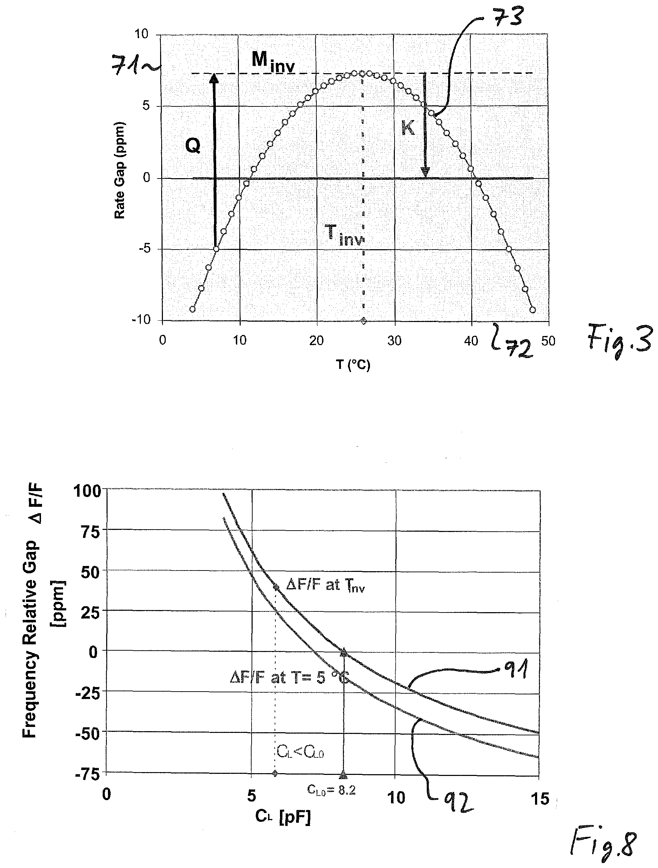

Fig. 3 shows a schematic representation of the behaviour of the frequency 71 of a tuning fork crystal as a function of the temperature 72. The frequency 73 is shown as variation around the ideal frequency having received the value 0. The reference Q is used for the correction dependent upon the temperature and K is the correction independent of the temperature, i.e. is related to the offset correction.

It is well known that the variation of a tuning fork crystal frequency 73 can be described by a quadratic function according to the temperature 72. Tᵢₙᵥ is the temperature where the quartz shows the highest frequency, usually around 25° C. The compensation of this drift requires a function Q(T) of same nature but with opposite sign. Such a function can be generated using a quadratic conversion of the number of pulses P(T).

The signal Q(T) must fulfil several conditions in order to have the temperature compensation optimally adapted to both the quartz 101 and relaxation oscillator 105 used in the watch. The calibration procedure used for the temperature compensation of a quartz oscillator requires three pairs of values of the quartz frequency and of the relaxation oscillator period. The calibration consists in measuring the periods D1_{T1}, D2_{T2} and D3_{T3} derived from the relaxation oscillator and the relative gap of the quartz frequency Y_{T1}, Y_{T2} and Y_{T3} in comparison with a nominal value of 32'768 Hz. Therein T1, T2 and T3 are three different temperatures, e.g. the temperatures with the reference numerals 51, 52 or 53 in Fig. 1, wherein the absolute values of these temperatures do not matter. The resulting function Y(D) allows explicit calculation of the parameters needed to program the quadratic thermal compensation Q(T), since the parabolic function 30 as shown in Fig. 1 is well defined with three such values. It has to be noted that the temperature values 51, 52 and 53 do not need to be known to perform this calibration procedure.

Since the procedure makes a reference to the nominal value of 32'768 Hz, it does not matter, at which place in time the calibration takes place. This can be done during any stage of the production of a watch or other electronic device having a time basis.

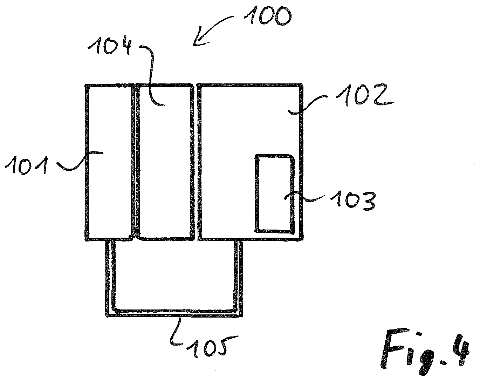

Fig. 4 shows a schematical representation of a device 100 with temperature compensation of a time basis driven by a quartz crystal oscillator 101. The quartz oscillator 101 is contained in a package which is connected through electrical contacts 105 with a control unit 102. The control unit 102 can comprise different control circuits according to any application where the stable quartz oscillator 101 may be used, i.e. watches, GPS-devices and other devices having a need for a temperature compensated time basis. Usually such a control unit 102 can be realized within an ASIC. According to the invention, said control unit 102 comprises a relaxation circuit 103. In order to perform the calibration the quartz oscillator 101 is thermally connected with the relaxation circuit 103 contained in the control unit 102 through a thermal connector 104. It is noted that thermal connector 104 as well as electrical connector lines 105 can be used intermittently in the production chain, i.e. the final device can comprise a different thermal connector 104 and/or different electrical connections, if only the close thermal contact is achieved within the final mounting stage of the device. The circuit 103 can also be outside the control unit 102.

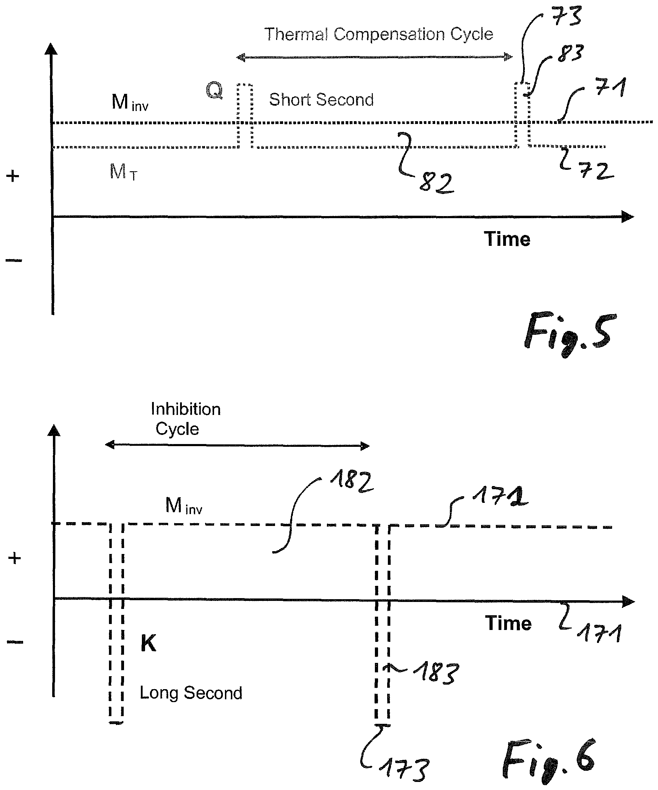

The present invention is based on the insight that the method and device carry out two different correction steps. These steps are called "Preset" and "Inhibition" and are explained in connection with Fig. 5 and 6.

Fig. 5 shows a schematic representation of the temperature compensation of the watch rate. M_{INV} is the rate when the watch is at the temperature of quartz inversion. Reference numeral 71 shows the length of a time basis, e.g. a second in relation to a basis in arbitrary units. In this representation, it is considered that the line 71 shows the correct length of a second. M_{T} corresponds to the horizontal line 72, e.g. to the length of a uncorrected rate at temperature T, which is longer (frequency is lower). Therefore within the thermal compensation cycle a shorter second 73 is introduced. Letter Q makes the connection to the compensation as shown in Fig. 3. The correction is such that the surface 83 between the line 73 of the shorter second and line 71 is equal to the surface 82 between the lines 72 and 71 in the remaining time. It is clear from Fig. 5 that the schematic representation is not drawn to scale.

The "Preset" procedure which is realized according to Fig. 5 sets a start counter value. The number counted to the maximum count is then smaller than the number when starting at zero.

The "Inhibition" procedure is then shown in connection with Fig. 6 showing a schematic representation of the rate adjustment by inhibition. This correction independent of the temperature is obtained by inserting a longer second period at regular intervals. In this respect the embodiment of Fig. 6 start with the assumption that the correction according to Fig. 5 has already be executed. Therefore M_{T} has already shifted in a corrected M_{T} at Mᵢₙᵥ. It is noted that the offset correction according to Fig. 6 could also be executed independently and prior to the correction of Fig. 5, if the temperature remains constant. The horizontal line 172 relates to the uncorrected quartz oscillator. Although reference numeral 172 shows the length of a time basis, e.g. a second in relation to a basis in arbitrary units, it is contemplated that the corrected time basis would be the line 171.

Mᵢₙᵥ therefore corresponds to the horizontal line 172, e.g. to the length of a uncorrected rate, which is shorter (frequency is higher). Within the offset compensation cycle a longer second 173 is introduced. Letter K makes the connection to the compensation as shown in Fig. 3. The correction is such that the surface 183 between the line 173 of the longer second and line 171 is equal to the surface 182 between the lines 172 and 171 in the remaining time. It is clear from Fig. 6 that the schematic representation is not drawn to scale.

The procedure of inhibition consists in eliminating a given number of pulses at the input to a counter. The maximum count is therefore the sum of the number of inhibited pulses plus the counter range. The modifications caused by both methods have opposite signs and correspond schematically to vectors Q and K in figure 3.

Preferably the function "Preset" is first programmed and makes a positive correction. This is equivalent to accelerate the watch rate or to increase the quartz frequency. The correction depends on the temperature and can be directly calculated based on three counter values obtained at different temperatures. The thermal drift of the quartz is compensated such that the rate is constant and equal to the rate at temperature of quartz inversion T_{INV}. For practical purposes, the correction Q is obtained by inserting periodically a shorter second. For example, every four minutes one second period is shorter than the others.

The rate correction "Inhibition" also known as "offset correction" corresponds to vector K in Fig. 3. The correction is negative. This is equivalent to decreasing the watch rate or the clocking signal of another electronic device having a temperature compensated time basis. This numeric adjustment method of the rate is well known and used in most quartz watches. The inhibition is done by periodically inserting a longer second. For example, every four minutes one second period is longer than the others in order to slow down the rate. This correction does not depend on the temperature. The value K is calculated on the basis of the measurement of the average rate after the temperature compensation. Thanks to the prior adjustment of the temperature compensation, the rate adjustment procedure can be applied at whatever temperature later during the production flow. This allows the environmental constraints during the frequency adjustment to be relaxed. Generally, for watches without a temperature compensated rate, the adjustment consists in cancelling the rate error at room temperature or at a given temperature setting, for example, the average temperature of the watch worn by a person.

Moreover, in order to distinguish between both functions during the measurement, the temperature compensation and the inhibition occur periodically and alternately, for example every two minutes as shown in Fig 7. The correct time line would be the dashed line 271. The "uncorrected" length of a second would be represented by line 272. This time basis is corrected through a longer second 274 dues to offset correction and a shorter second 273 due to temperature correction. The correction 274 is fixedly programmed and the correction 273 is the current correction at the current temperature of the device. The surfaces 283 of shorter time basis parts are equal to the surface 284 of longer time basis parts, i.e. the user of the device sees the behaviour of the device as being on the time line 271.

This calibration procedure has the following advantages
- Q, correction for the temperature compensation or "Preset", and K, correction for the inhibition or "offset correction" have opposite signs.
- Both adjustments are completely independent. The programming of the correction of the offset K is preferably performed after the thermal compensation Q to allow the offset to go near its limiting value, since the variation of the frequency is logarithmic.
- The accurate adjustment of the offset correction by inhibition can take place after mounting the quartz in the electronic device, e.g. after the mounting of the movement in the watch box, at delivery and by taking into account an independent rate of the storage temperature, integrated over a significant time period (several hours or days).
- The quartz oscillator is sensitive relating to nearby objects as the movement. Therefore it will be influenced after assembly of the electronic module and furthermore after insertion of the assembled device in the watch casing.

If the frequency at the temperature of the quartz inversion is higher than 32'768Hz, quartzes with larger frequency adjustment tolerances can be used. With the usual temperature compensation methods, all points on the parabola of Fig. 3 must be above the nominal value of 32'768Hz for a given temperature slot, from 0°C to 50°C for example. This is because the correction using the inhibition can only correct the ppm gap downward which means slowing down the quartz rate.

Fig. 8 shows the influence and dependency of the load capacitance relative to the frequency relative gap of a quartz oscillator. The embodiment shows an improvement of the oscillator stability thanks to a more favourable capacitive load. The standard specification of e.g. 32'768Hz quartzes with a nominal load capacitance C_{L0} considers only the tolerance around room temperature. In this mode, it is necessary and sufficient that the temperature characteristic of the quartz behaviour associated to the integrated circuit uses values above 32'768Hz (level 0 ppm in Fig. 3). Fig. 8 presents the relative gap of the frequency in function of the load capacitance C_{L}. This is shown for two different temperatures: The gap 91 at the inversion temperature Tᵢₙᵥ close to room temperature and the gap 92 at a temperature of 5°C. In order to ensure a frequency higher than 32'768Hz at whatever temperature, it is clear that the operation point must be shifted on the left with a value of C_{L} lower than C_{L0}. The slope of the characteristic at this point is steeper; the relative variation of the frequency induced by a capacitance disturbance will have higher amplitude and will then be less stable.

Although reference is made to a 32'768 Hz tuning fork crystal, it is clear that any different type of quartz crystal can be used, if three temperature values are measured to provide parameters for a near parabolic function of temperature variation. It has to be noted that obtaining four or more values at different temperatures allow obtaining parameters to program higher order functions of the temperature variation. It is only important that the sensitivity of the second oscillator is significantly (>10times, preferably >100 times or more) higher than the sensitivity of the quartz oscillator on temperature.

## Claims

1. Method for temperature compensation of a time basis, driven by a quartz crystal oscillator (101) having a parabolic frequency characteristic with temperature, wherein a second oscillator (103) is used having a linear frequency dependency (20) on temperature, with the steps of:
- counting pulses (65) of the quartz crystal oscillator (101) for at least three, and preferably only three, different temperatures (51, 52, 53) during time intervals given by a predetermined number of pulses (61) of the second oscillator (103), wherein the pulses (65) counted for each temperature are representative for said temperature,
- calculating the function of variation (20) of the second oscillator period in combination with the quartz frequency (30) both with temperature based on said three or more, preferably three, pulse count values per oscillator (101, 103), and
- using said calculated function to correct the frequency change of the quartz crystal oscillator (101) due to temperature changes at any operating temperature.

2. Method according to claim 1, wherein said quartz crystal oscillator (101) is intermittently mounted in thermal (104) and electric (105) connection with said second oscillator (103) for evaluation of the parameters for the parabolic function of variation (30) of the quartz crystal oscillator (101).

3. Method according to claim 1, wherein the three temperatures are chosen near 8° C, near 38°C and near room temperature, especially near 23° C.

4. Device with a temperature compensated time basis, comprising a quartz crystal oscillator (101) and a second oscillator (103) having a linear frequency dependency (20) on temperature, **characterized in that** the device further comprises a control unit (102) providing correction signals (73, 173, 273, 274) based on a programmed temperature compensation according to a method according to one of claims 1 to 3.

5. Device according to claim 4, wherein the quartz crystal oscillator (101) is a 32'768 Hz tuning fork oscillator.

6. Device according to claim 4 or 5, wherein the second oscillator (103) is a relaxation oscillator or a RC-oscillator.

## Patentansprüche

1. Verfahren zur Temperaturkompensation einer Zeitbasis, angetrieben durch einen Quarzkristalloszillator (101) mit einer parabolischen Frequenzcharakteristik über die Temperatur, wobei ein zweiter Oszillator (103) mit einer linearen Frequenzabhängigkeit (20) in Bezug auf die Temperatur verwendet wird, mit den Schritten:
- des Zählens von Impulsen (65) des Quarzoszillators (101) für mindestens drei, vorzugsweise nur drei, verschiedene Temperaturen (51, 52, 53) während Zeitintervallen, die durch eine vorbestimmte Anzahl von Impulsen (61) des zweiten Oszillators (103) vorgegeben sind, wobei die für jede Temperatur gezählten Impulse (65) für diese Temperatur repräsentativ sind,
- des Berechnens der Funktion der Variation (20) der Periode des zweiten Oszillators in Kombination mit der Quarzfrequenz (30) sowohl in Bezug auf dieTemperatur basierend auf den besagten drei oder mehr als drei, vorzugsweise drei, Impulszählwerten pro Oszillator (101, 103), und
- des Verwendens der berechneten Funktion, um die Frequenzänderung des Quarzoszillators (101) aufgrund von Temperaturänderungen bei jeder Betriebstemperatur zu korrigieren.

2. Verfahren nach Anspruch 1, wobei der besagte Quarzkristalloszillator (101) intermittierend in thermischer (104) und elektrischer (105) Verbindung mit dem besagten zweiten Oszillator (103) zur Auswertung der Parameter für die parabolische Funktion der Variation (30) des Quarzkristalloszillators (101) montiert wird.

3. Verfahren nach Anspruch 1, wobei die drei Temperaturen nahe 8° C, nahe 38°C und nahe Raumtemperatur, insbesondere nahe 23° C, gewählt werden.

4. Vorrichtung mit einer temperaturkompensierten Zeitbasis, bestehend aus einem Quarzkristalloszillator (101) und einem zweiten Oszillator (103) mit einer linearen Frequenzabhängigkeit (20) von der Temperatur, **dadurch gekennzeichnet, dass** die Vorrichtung ferner eine Steuereinheit (102) umfasst, die Korrektursignale (73, 173, 273, 274) basierend auf einer programmierten Temperaturkompensation nach einem Verfahren nach einem der Ansprüche 1 bis 3 liefert.

5. Vorrichtung nach Anspruch 4, wobei der Quarzoszillator (101) ein 32'768 Hz Schwinggabeloszillator ist.

6. Vorrichtung nach Anspruch 4 oder 5, wobei der zweite Oszillator (103) ein Relaxationsoszillator oder ein RC-Oszillator ist.

## Revendications

1. Procédé de compensation de température d'une base de temps, commandé par un oscillateur à quartz (101) ayant une caractéristique de fréquence parabolique par rapport à la température, dans lequel on utilise un deuxième oscillateur (103) ayant une dépendance de fréquence linéaire (20) par rapport à la température, avec les étapes suivantes:
- compter les impulsions (65) de l'oscillateur à quartz (101) pour au moins trois, et de préférence seulement trois, températures différentes (51, 52, 53) pendant des intervalles de temps donnés par un nombre prédéterminé d'impulsions (61) du deuxième oscillateur (103), dans lequel les impulsions (65) comptées pour chaque température sont représentatives de ladite température,
- calculer la fonction de variation (20) de la période du deuxième oscillateur en combinaison avec la fréquence de quartz (30) à la fois avec la température basée sur lesdites trois ou plus, de préférence trois, valeurs de comptage d'impulsions par oscillateur (101, 103), et
- utiliser ladite fonction calculée pour corriger la variation de fréquence de l'oscillateur à quartz (101) due à des changements de température à n'importe quelle température de fonctionnement.

2. Procédé selon la revendication 1, dans lequel ledit oscillateur à quartz (101) est monté de façon intermittente en connexion thermique (104) et électrique (105) avec ledit deuxième oscillateur (103) pour une évaluation des paramètres de la fonction parabolique de variation (30) de l'oscillateur à quartz (101).

3. Procédé selon la revendication 1, dans lequel les trois températures sont choisies près de 8°C, près de 38°C et près de la température ambiante, en particulier près de 23°C.

4. Dispositif à base de temps compensée en température, comprenant un oscillateur à quartz (101) et un ddeuxième oscillateur (103) ayant une dépendance en fréquence linéaire (20) par rapport à la température, **caractérisé en ce que** le dispositif comprend en outre une unité de commande (102) fournissant des signaux de correction (73, 173, 273, 273, 273, 274) basés sur une compensation de température programmée selon un procédé selon l'une des revendications 1 à 3.

5. Dispositif selon la revendication 4, dans lequel l'oscillateur à quartz (101) est un oscillateur à lames vibrantes de 32'768 Hz.

6. Dispositif selon la revendication 4 ou 5, dans lequel le deuxième oscillateur (103) est un oscillateur de relaxation ou un oscillateur RC.
